# EUROPÄISCHE PATENTSCHRIFT

(11) **EP 1 955 381 B1**
(45) Veröffentlichungstag und Bekanntmachung des Hinweises auf die Patenterteilung: **14.03.2018**
(21) Anmeldenummer: 06817719.5
(22) Anmeldetag: 27.11.2006
(51) Int. Cl.: H02S 20/30, H02S 20/24, F24J 2/54

(54) **SOLARANLAGE SOWIE VERFAHREN ZUM BETRIEB**
SOLAR SYSTEM AND METHOD FOR THE OPERATION THEREOF
INSTALLATION SOLAIRE ET PROCEDE POUR LA FAIRE FONCTIONNER

(30) Priorität: 29.11.2005 EP 05405676
(43) Veröffentlichungstag der Anmeldung: 13.08.2008
(73) Patentinhaber: Frauenknecht, Hana, 6403 Küssnacht (CH)
(72) Erfinder: FRAUENKNECHT, Hana, 6403 Küssnacht (CH); MOLL, Rudolf, 6430 Schwyz (CH); PALFFY, Sandor, 5408 Ennetbaden (CH)
(74) Vertreter: Wächter, Roland
(86) Internationale Anmeldenummer: PCT/CH2006/000661
(87) Internationale Veröffentlichungsnummer: WO 2007/062537

(56) Entgegenhaltungen:
- DE-A1- 10 134 298
- JP-A- 2001 102 613
- JP-A- 2002 061 962
- JP-A- 2003 324 210
- US-A- 4 334 521
- US-A- 5 228 924
- US-A1- 2002 139 413
- US-B1- 6 465 725

## Beschreibung

Die vorliegende Erfindung bezieht sich auf eine Solaranlage gemäss dem Oberbegriff des Anspruchs 1 sowie auf ein Verfahren zu deren Betrieb nach Anspruch 9.

Es ist allgemein bekannt, dass durch die Nachführung von Solarpanels in zwei Achsen gegenüber stationären, nur in Nord-Südrichtung angeordneten Panels ein zusätzlicher jährlicher Energiegewinn von bis zu 40 Prozent erreichbar ist. Bei in Nord-Südrichtung mit einer Elevation von 20° bis 40° angeordneten Panels, welche sich beidseitig auf der Elevationsachse um 60° aus der Waagrechten ausschwenken lassen, kann mit einem zusätzlichen Energiegewinn von etwa 30 Prozent gerechnet werden.

Aus der US -A- 5,228,924 ist ein sturmfestes schwenkbares Solarpanel bekannt. Zwischen dreieckförmigen Stützen sind auf einer feststehenden Welle wenigstens zwei Module kippbar gelagert, wobei benachbarte Module miteinander mechanisch gekoppelt sind. Sie werden durch einen innerhalb der Stützen angeordneten reversierbaren elektromechanischen Spindelantrieb mittels Teleskopstangen um insgesamt 130° von Ost nach West verschwenkt. Die Steuerung des Antriebs erfolgt nach einem zeitabhängigen Programm, entweder elektromechanisch oder durch einen Computer.

Nachteilig bei dieser Anlage ist der relativ hohe Energiebedarf für den Antrieb und dessen Steuerung, so dass zu deren Speisung ein Anschluss an das Stromnetz erforderlich ist. Aus antriebstechnischen und kinematischen Gründen ist die Anlage nur mit einer horizontal angeordneten Drehachse versehen, so dass der Sonnenstand (Elevation) nicht berücksichtigt ist, was vor allem in den Wintermonaten an Standorten nördlich des nördlichen bzw. südlich des südlichen Wendekreises zu einer stark reduzierten Solarernte führt. Das Modell einer zweiachsigen Solaranlage (JP 2002 061962 A) verzichtet ebenfalls auf anderwärts übliche Sensoren; die Steuerung wird durch die Anlage selbst gespeist.

Hier handelt es sich dabei um keine allwettertaugliche Konstruktion; die frei liegende Schneckengetriebe an jedem Solarmodul zur Einstellung der Azimutlage sind extrem störanfällig. Auch beim vorgesehenen Intervallbetrieb der Antriebsmotoren belasten diese die Gesamtenergiebilanz und führen beim Betrieb zu einem unverhältnismässig hohen Spannungsabfall in den Solarmodulen, entstehen doch durch die Vielzahl an Schneckengetriebe (aufgezeigt: 22) enorme Reibungsverluste. Eine weitere zweiachsige Anlage ist aus JP -A- 2001 102613 bekannt. Hier ist ein in Elevationsrichtung horizontal schwenkbares Solarpanel auf einem Podest gelagert, welches auf einer in Azimutrichtung drehbaren Säule befestigt ist. Dies erlaubt über Elektromotoren und Getriebe das Solarpanel präzise auf die Sonne auszurichten. - Nachteilig ist hier insbesondere der gewichtige Aufbau der Anlage, der entsprechend grosse Antriebsenergien erfordert. Generell haben bisher zur Energieerzeugung ein- und zweiachsig drehbare Solarpanels eine nur geringe Verbreitung gefunden, gelten sie doch als teuer und störanfällig.

Es ist daher Aufgabe der Erfindung eine Solaranlage zu schaffen, die betriebssicher ist und mit wirtschaftlich vertretbarem Aufwand gegenüber stationären Solaranlagen einen erheblich höheren Ertrag abgibt. Insbesondere soll die tägliche Sonnenscheindauer besser genutzt werden. So soll die Anlage auch in den frühen Morgenstunden und bis zum Sonnenuntergang elektrische Energie liefern. Auch bei diffuser Strahlung muss ein den Solarmodulen entsprechender maximaler Ertrag erzielbar sein. Die Anlage muss wetterfest aufgebaut sein, d.h. sie soll beispielsweise bei allen auf einem Hausdach auftretenden Temperaturen und extremen Windverhältnissen (Stürmen) funktionsfähig bleiben; sie muss auch starken Böen und Schneelasten unbeschadet Stand halten. Es sollen deshalb in der Anlage Vorkehrungen getroffen werden, um bei einem gegen den Wind gedrehten Solarpanel die auf die mechanische Konstruktion wirkenden Kräfte zu reduzieren. Ebenfalls soll im Winter die Bildung einer zusammenhängenden Eis- und/oder Schneedecke auf der Oberfläche des Solarpanels verhindert werden.

Die mechanische Konstruktion der Anlage soll derart einfach sein, dass sie überall, wo die behördliche Bauzulassung erfolgt, mit einfachsten Mitteln aufstell- und betreibbar ist. Sie soll auch Solarmodule bestehender stationärer Anlagen aufnehmen können und an deren Stelle verwendbar sein. Dies ermöglicht auch ein ökologisch und ökonomisch einwandfreies Nachrüsten der bisheriger Anlagen unter Beibehaltung der gesamten elektrischen Installation.- Durch das Nachrüsten wird die durchschnittliche jährliche Solarernte um etwa 30 % erhöht, nicht aber die maximale Leistung beim höchsten Sonnenstand, so dass auch die alten Wechselrichter unverändert verbleiben können.

Diese Aufgabe wird durch die Merkmale der Patentansprüche gelöst.

Gemäss Anspruch 1 wird die Energie zum Antrieb des Verstellmotors direkt einer Leistungszelle (d.i. ein Solarmodul) entnommen, wodurch Fremdeinspeisungen jeglicher Art entfallen. Damit steht zu jeder Zeit am Tage ausreichend Energie zum intervallweisen Kippen sämtlicher Module auf einer Drehachse zur Verfügung, ohne die Leistungsbilanz des angeschlossenen Solarmoduls spürbar zu beeinträchtigen.

Ebenfalls sind Speicherbatterien, deren elektrische Leistung bekanntlich temperaturabhängig ist, nicht erforderlich. Die Schwenkbewegung erfolgt dadurch, dass der Antrieb sich um das feststehende Zahnrad, in Intervallen, um einen vorbestimmten Winkel dreht und über seine Grundplatte die Trägerstruktur ("Support") der Solarmodule mitbewegt ("schwenkt"). Dieser Bewegungsablauf reduziert den technischen Aufwand und den Strombedarf gegenüber einer kontinuierlichen Nachführung beträchtlich.

Nach dem Verfahren nach Anspruch 9 wird eine optimale energiesparende Ansteuerung eines Antriebs für Solaranlagen erreicht. Der dafür notwendige Energiekonsum ist sehr gering; er entspricht etwa demjenigen einer momentanen Abschattung eines einzigen Moduls durch eine vorüberziehende Wolke. Die Rückstellung des Panels in die morgendliche Ausgangslage kann motorisch oder rein mechanisch über eine im Tagesablauf gespannte Feder geschehen. Die im Patentanspruch charakterisierte Steuerung erübrigt Sensorzellen und dgl. sowie entsprechende Regelkreise und ermöglicht den Bau störungsfrei arbeitender Anlagen. Ungeachtet von den aktuell herrschenden atmosphärischen Bedingungen werden durch die Solarmodule immer ein Optimum an Energie aufgenommen. Dies auch bei bedecktem Himmel oder vorüberziehenden Wolken, weiss doch die Steuerung immer wo sich die Sonne befindet. Somit wird das Panel auch bei diffuser Strahlung auf das Strahlungsmaximum gerichtet.

Besonders effizient ist die diskontinuierliche Steuerung nach vorgegebenen Winkelstellungen. Auf Grund der hohen Strahlungsempfindlichkeit und der relativen Unempfindlichkeit auf kleine Winkeländerungen entsteht in modernen Solarmodulen keine messbare Leistungseinbusse gegenüber einer kontinuierlichen Nachführung nach der Sonne.

Nachfolgend sind technische Weiterbildungen des Erfindungsgenstands beschrieben, welche diesen optimieren:
Die Ausgestaltung von Luftspalten durch elastische Distanzhalter zwischen einzelnen Solarmodulen verhindert bei einer Anströmung des Panels (Wind, Böen) einen "Tragflügeleffekt". Bereits ein Spalt von mehr als 15 mm ergibt einen ausreichenden Druckausgleich (Entlastung) zwischen der Unter- und der Oberseite des ganzen Solarpanels. Bei Schneefall kann sich, wiederum durch die Spalten, auf dem Panel, wird die Bildung einer zusammenhängenden Schneedecke erschwert, so dass die Verminderung der elektrischen Leistung durch Schneeablagerungen gegenüber aneinander stossenden Solarmodulen geringer und/oder nur von kürzerer Dauer ist.

Die Lagerung der Solarmodule auf der Breitseite eines U-Profils erlaubt deren einfache und sichere Halterung und bietet gleichzeitig Platz zum Einbau von Lagerklötzen, welche die Drehachse der Anlage aufnehmen. Zudem lässt sich dadurch die über die Mittelachse sich erstreckende Fläche nutzen. Dies im Gegensatz zu einem Antrieb mit einem Rohrmotor und mittig an diesem anliegenden Zellen. Ein kleineres polares Massenträgheitsmoment sowie geringere Unwuchten durch Asymmetrien sind weitere Vorteile.

Empfehlenswert, insbesondere bei grösseren Modulen ist auch eine seitliche Lagerung und damit Zentrierung der Module in einem kleineren U-Profil.

Ein Federstab kann das ungebremste Solarpanel selbständig in seine horizontale Null-Lage führen. Dies vereinfacht den Steuerungsvorgang und erhöht die Systemsicherheit, lässt sich doch dadurch das Panel auf einfachste Weise in eine nächtliche Ruhelage bringen. Diese kann zusätzlich vor aufziehenden orkanartigen Stürmen in gleicher Weise auch tagsüber erstellt werden. Es sind auch mehrere Federstäbe unterschiedlicher Dimensionen denkbar, die unterhalb des Solarpanels angebracht eine objektspezifische Federkennlinie ergeben.

Das durch den Federstab ("Biegestab") vom Antrieb aufzubringende grössere Drehmoment lässt sich durch eine Optimierung des Antriebs (Getriebeverhältnis und Motordrehzahl) problemlos erreichen.- Der Stab lässt sich leicht an die Antriebsteuerung anpassen, so kann er vorgespannt, d.h. im Zentrum verdreht werden, so dass sich die Ruhelage des Panels in nach Osten gekippter Richtung einstellt. Dies vereinfacht einerseits das Steuerprogramm und erlaubt anderseits bereits am frühen Morgen einen solaren Energiegewinn zu erzielen.

Bevorzugt ist eine Anordnung mit einer Blattfeder, welche stirnseitig am Panel auf Rollen geführt und zentral auf der feststehenden Welle des Panels durch Verdrehen in ihrer Federkraft einstellbar ist.

Eine Hohlwelle als Trägerachse wirkt sich gewichtsvermindernd aus, ohne dass Stabilitätsverluste entstehen, was insbesondere bei Montagen auf Dächern von grosser Bedeutung ist. Bei längeren Wellen erlauben aufgesetzte (aufgeschrumpfte) Gleitbüchsen die Verwendung billiger Rohre und verhindern zusätzlich ein Durchbiegen unter Last.

Realisiert wurde auch eine in der Hohlwelle gelagerte Torsionsfeder, welche entweder alleine oder in Verbindung mit einem Federstab eine progressive Federkennlinie nachbilden lassen.

Besonders einfach und servicefreundlich ist die Kraftübertragung des Antriebs mittels eines Segmentes eines Zahnkranzes das vorzugsweise im Bereich des oberen Endes der Drehachse angeordnet wird. Entsprechend den geographischen Verhältnissen genügt ein Zahnsegment von 90° (bergiger Standort) oder ist ein Schwenkbereich von 120° (Flachland ohne Überhöhungen) zweckmässig. Sind am Standort einseitig Abschattungen zu erwarten, so lässt sich das Zahnsegment auf der Welle soweit verdrehen, dass die Strahlung auf der freien Seite bevorzugt, d.h. länger, vom Panel aufgenommen wird.

Eine Schaltwippe für das Motorteil mit Vorgelege erlaubt eine rasche und energiesparende Rückstellung eines ausgeschwenkten Solarpanels in seine horizontale Ruhelage.

Bewährt hat sich zur Betätigung der Schaltwippe ein kurzzeitig einschaltbarer Schaltmagnet. Für starken Winden ausgesetzte Gebiete empfiehlt sich ein zusätzlicher Verriegelungsmagnet an der Schaltwippe.

Eine Erhöhung der Systemsicherheit und eine nochmals reduzierte Belastung der einzelnen Solarmodule ist durch einen verteilten Energiebezug möglich.

Obwohl die Schwenkbewegung des Panels ein hohes Untersetzungsverhältnis zwischen Motor und Zahnradsegment erfordert, empfiehlt sich ein Stirnradgetriebe aufgrund des hohen mechanischen Wirkungsgrades.

Bei grossen Solaranlagen mit mehreren gleichartigen Panels kann der wirtschaftliche Aufwand massiv reduziert werden, wenn diese miteinander gekoppelt sind. Als mechanische Treibmittel eignen sich Zahnriemen, Ketten oder Gestänge. Ebenfalls bieten sich moderne Funkübertragungssysteme (WLAN, Bluetooth) an, welche eine kostengünstige elektrische Synchronisierung der einzelnen Antriebe ermöglichen.

Eine Positionssteuerung mittels Magnetschaltern (Reed-Relais) oder Hallsensoren vereinfacht den elektronischen Aufwand sehr. Sie gewährleisteten Systemsicherheit, insbesondere die elektromagnetische Verträglichkeit (EMV) bei Anlagen, die an exponierten und/oder blitzgefährdeten Stellen aufgebaut sind. Besonders einfach und günstig ist der Einbau der Positionsmelder im Antrieb. Diese sind mit Vorteil im oder am Zahnradsegment installiert, welches den Support mit den Solarmodulen trägt und dreht.

Von grosser Bedeutung ist die effiziente Speicherung der Schaltenergie zum Auskuppeln des Antriebs und ggf. der Stromversorgung für die Steuerung. Nach dem Auskuppeln stellt sich das Solarpanel - durch seinen Feder- und/oder Torsionsstab - in eine Ruhestellung oder Ausgangslage und kann bereits am frühen Morgen diffuses Licht empfangen und den Kippvorgang in östlicher bzw. von der östlichen Ausgangslage in westlicher Richtung steuern. Die hierfür notwendigen Kräfte lassen sich mittels zusätzlicher Federn oder der Wahl eines entsprechenden Schaltmagneten abstimmen, so dass auch in beliebigen Winkellagen kein Windstoss das Ausklinken in die Ruhestellung bewirken kann.

Optimal ist eine Aufladung des Kondensators über eine Sperrdiode weil dadurch der Kondensator bis in die Nacht hinein die maximale Klemmenspannung zur Verfügung stellt.

Durch den Einsatz eines zweiten Magneten, der zur Verriegelung der Schaltwippe dient, lässt sich der erste Magnet (Schaltmagnet) kleiner dimensionieren und die Wippe mit kleineren Federn versehen, ohne dass das der Abtrieb des Vorgeleges aus dem Zahnsegment ausrückt. Die notwendige Schaltverzögerung des ersten gegenüber dem zweiten Magneten entsteht durch die unterschiedlichen inhärenten mechanischen und elektrischen Hysteresen, sie lässt sich aber auch elektronisch auf 100 - 200 ms einstellen.

Die Verwendung der Anlage in Verbindung mit Notstrom-Installationen erhöht die Sicherheit von sensitiven Infrastrukturen, ohne dass eine Wartung der gesamten Anlage notwendig ist. Ebenfalls können mit dem Erfindungsgenstand grosse Solarparks realisiert werden.

Nachfolgend werden an Hand von Zeichnungen Ausführungsbeispiele der Erfindung erläutert, wobei für gleiche Funktionsteile gleiche Bezugsziffern verwendet sind.

Es zeigen:
- Fig. 1: eine an einer Ecke eines Flachdachhauses installierte Solaranlage mit schwenkbarem Panel und unten angeordneter Antriebseinheit und einer oberen, zentral eingespannten Rückstellfeder,
- Fig. 2: die Bauelemente der Antriebseinheit Fig. 1 mit abgenommener Schutzhaube in Draufsicht,
- Fig. 3: die Antriebseinheit Fig. 2 von der Seite betrachtet,
- Fig. 4: ein unteres Dreibein als Lagerung für eine feststehende Welle mit schwenkbarem Solarpanel, über Zahnriemen gekoppelt mit benachbarten Anlagen, mit einer unteren Rückstellfeder,
- Fig. 4a: eine Variante eines Solarpanels mit axialem Drehstab in einer feststehenden Hohlwelle, in einer teilweisen Schnittdarstellung,
- Fig. 5: eine Prinzipdarstellung einer Notstromversorgung mit Netzrückspeisung mit drei Solarpanels und einer Antriebseinheit,
- Fig. 6: ein vereinfachtes Ablaufdiagramm zur Steuerung der Solarpanels nach Fig. 5, mit charakteristischen Steuersignalen Sx,
- Fig. 7: eine drahtlose Übertragungsstrecke zur Abgabe der Steuersignale Sx gemäss Fig. 6 an die Solarpanel,
- Fig. 8: das Blockschaltbild einer alternativen, in die Antriebseinheit integrierten autonomen Steuerung,
- Fig. 9a-c: den zeitlichen Ablauf der Steuersignale für die Steuerung nach Fig. 8, in Abhängigkeit der Jahreszeiten,
- Fig. 10: zwei schräggestellte, mechanisch gekoppelte Solaranlagen mit einer einzigen Antriebseinheit,
- Fig. 11: einen Ausschnitt aus einem Solarpanel mit einer nichtlinearen Rückstellungsvorrichtung mittels Blattfeder in Ostlage (Morgen),
- Fig. 12: das Solarpanel Fig. 11 in Horizontallage (Mittag) und
- Fig. 13: das Solarpanel Fig. 11 in Westlage (Abend).

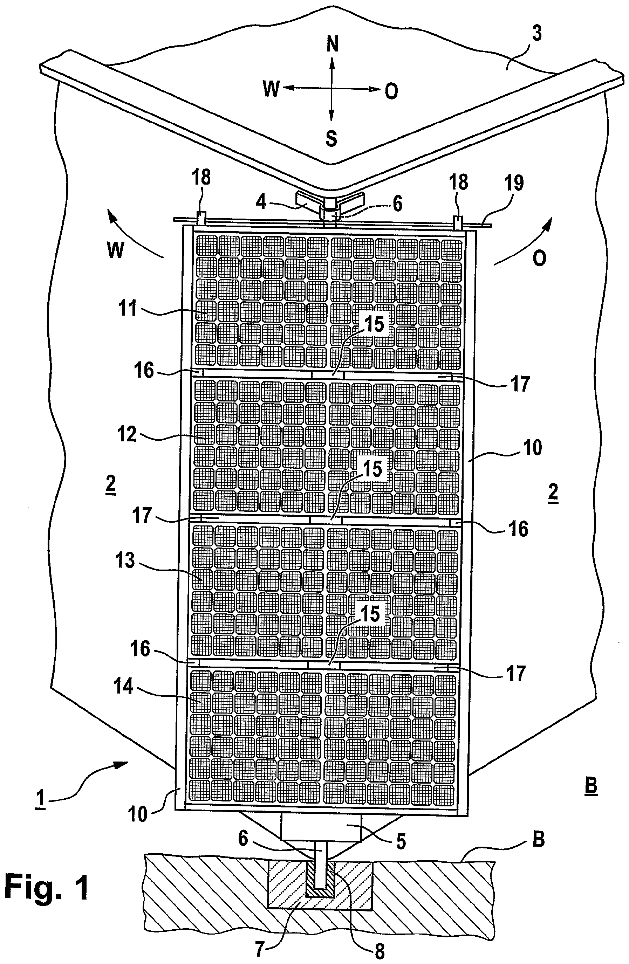

In Fig.1 ist mit 1 ein Solarpanel bezeichnet, welches an der Ecke von zwei unter einem Winkel von 90° aufeinander stossenden Hauswänden 2 plaziert ist. Das Solarpanel 1 ist im wesentlichen durch vier Solarmodule 11-14 gebildet, welche in einem Rahmen 10 aus einem U-Profil zusammengefasst und fixiert sind. Ein Flachdach 3 ist in üblicher Weise ausgestaltet; das Haus ist in seiner Diagonale in Nord-/Süd-Richtung ausgerichtet. Im oberen Teil der Hausecke ist eine Befestigung 4 für eine feststehende Welle 6 angebracht, welche in einer Lagerbüchse 8 gefasst und in Zementguss 7 im Betonfundament B einzementiert ist. Unterhalb des Solarpanels 1 befindet sich ein elektrischer Antrieb 5, der mechanisch mit einem zentralen Support 15 verbunden ist. Zwischen den einzelnen Solarmodulen 11-14 sind Distanzhalter 16, so dass zwischen den Modulen Luftspalte 17 gebildet sind, welche dem Druckausgleich bei Windbelastung dienen und gleichzeitig die Bildung einer zusammenhängenden Eisdecke verhindern. Oberhalb des Solarpanels 1 ragen zwei Führungsklötze 18 heraus, durch welche ein an der Welle 6 befestigter Federstab 19 geführt ist, der als Rückstellfeder für das ganze Panel 1 dient. Beide Teile 16 und 18 bestehen aus einem UV-beständigem Polymer.

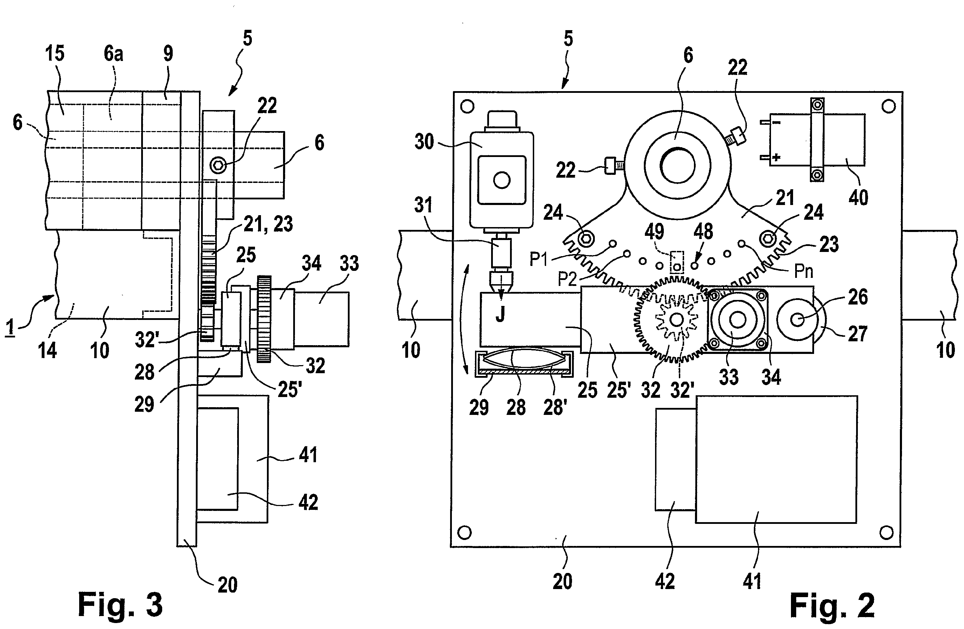

Gemäss Fig. 2 ist der elektrische Antrieb 5 als autonome Einheit auf einer Grundplatte 20 aufgebaut. Durch die Grundplatte 20 ist das Ende der als Hohlwelle ausgestalteten Welle 6 geführt, die mit einem Zahnradsegment 21 bestückt ist. Die Lage des Zahnradsegments 21 lässt sich durch Feststellschrauben 22 in seiner Winkellage justieren. Im Zahnradsegment 21 sind Positionsgeber eingelassen, die als Magnetstäbe 48 ausgebildet über einen Positionssensor 49 Positionssignale P1-Pn erzeugen. Auf dem Zahnradsegment 21 ragen endseitig Zapfen 24 heraus, die der mechanischen Wegbegrenzung dienen. Somit kann das Solarpanel 1, Fig. 1, um max. 90° verschwenkt werden. Eine Schaltwippe 25, 25' ist auf Lagerstellen 26, 27 endseitig drehbar geführt. Sie dient als Träger für einen handelsüblichen Getriebemotor 33 mit Getriebe 34 und Zwischenrädern 32, 32', welche eine Drehzahluntersetzung bilden und wobei das Zahnrad 32' (Ritzel) in die Verzahnung 23 des Zahnradsegmentes 21 eingreift.

Gehalten ist die Wippe 25 unterseitig durch Blattfedern 28, 28', welche in einem Federgehäuse 29 gelagert sind. Auf der Oberseite der Schaltwippe 25 liegt ein Stössel 31 auf, der Bestandteil des Ankers eines Schaltmagneten 30 ist. Auf der rechten oberen Seite der Grundplatte 20 ist ein Speicherkondensator 40 befestigt, der zur Ansteuerung des Schaltmagneten 30 vorgesehen ist. Im unteren Teil der Platte 20 ist eine elektronische Steuerung 41 angeordnet, über deren Anschlusskasten 42 eine hier aus Übersichtlichkeitsgründen nicht dargestellte Verkabelung angeschlossen ist. Seitlich zur Grundplatte 20 ist der Rahmen 10 ersichtlich, mit dem diese kraftschlüssig verbunden ist.

Von der Seite betrachtet erkennt man die Bestandteile der Fig. 2 in Fig. 3 in ihrer Tiefe. Ersichtlich ist hier wiederum der Rahmen 10, der mit seinem U-Profil die Solarmodule umschliesst. Ebenfalls erkennt man das durchgehende Hohlprofil der Welle 6 im Support 15 sowie den zugehörigen Träger 9 (Endflansch) für den Rahmen 10. Ein Lager 6a besteht aus einem gleitfähigen Polymer (Delrin, Handelsmarke der Firma DuPont, USA).- Im Betriebszustand ist die hier in einer Servicestellung befindliche Antriebseinheit um 180° gedreht, d.h. das gestrichelt bezeichnete Solarmodul 14 befindet sich dann oben. Die sehr einfache Lagerung der Welle 6 in Lagern 6a hat bestechende Eigenschaften: Sie ist selbstschmierend und hat bei Regen und Schnee bessere Schmiereigenschaften als im trockenen Zustand, dies völlig im Gegensatz zu anderen Konstruktionen.

Aus den Fig. 1 bis 3 ergibt sich, dass der in Gang gesetzte Getriebemotor 33 das ganze Antriebssystem 5 mit dem Support 15, dem Rahmen 10 und den Modulen 11-14 um die Welle 6 dreht bzw. schwenken kann.

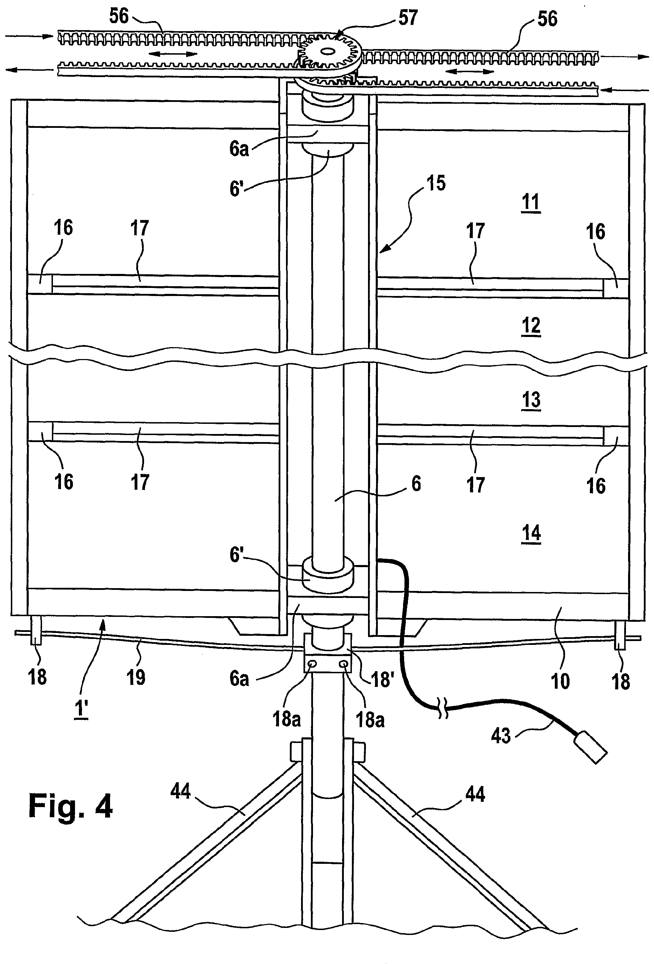

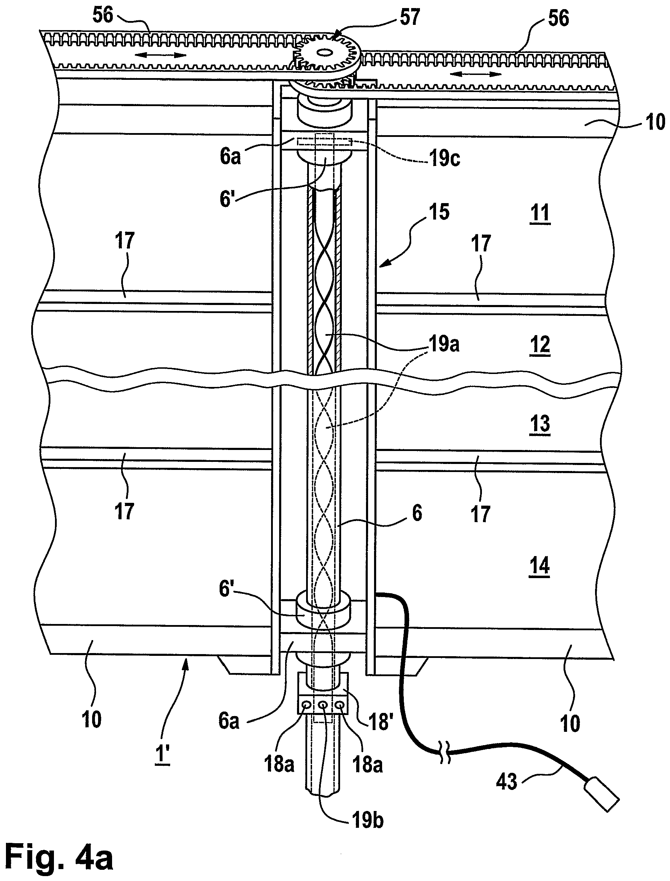

Eine Variante eines Solarpanels 1', im Verbund mit weiteren Panels 1' ist in Fig. 4 dargestellt. Die Welle 6 ist unter einem Elevationswinkel von 45° gegen Süden gerichtet. Gegenüber Fig. 1 bis 3 ist hier speziell eine Gleitbüchse 6' vorgesehen, welche die Welle 6 verstärkt und deren Durchbiegung reduziert. Am oberen Ende der Welle 6 sind zwei Antriebsräder 57 für Zahnriemen 56 angeordnet; eine Antriebseinheit 5 befindet sich in dieser Version auf einer Welle 6 einer benachbarten Anlage. Dadurch ist leicht ein Synchronlauf von zueinander parallelen Anlagen mit minimalem technischen Aufwand möglich. Ersichtlich ist in dieser Figur zudem ein Anschlusskabel 43, ein genormtes, sogenanntes Solarkabel mit Stecker.

Die Zahnriemen 56 lassen sich auch durch gebogen ausgestaltete Gestänge ersetzen, was insbesondere in Gegenden, wo keine Vereisungsgefahr besteht, vorteilhaft sein kann.

Alternativ ist, hier nicht dargestellt, ein separater Antrieb 5 vorgesehen, der isoliert, d.h. ohne Solarpanel aufgestellt ist. Sein Antriebsrad 57 treibt die Zahnriemen 56 mit den einzelnen Panels 1',1" an.

Fig. 4a zeigt eine Variante einer Rückstellung mit einem in der Hohlwelle 6 vereinfacht dargestelltem Drehstab 19a, auch Torsionsfeder genannt. Dieser Stab 19a ist an seiner unteren Endseite durch eine Schraube 19b fixiert (in einer nicht gezeichneten Klemme), deren Muttergewinde befindet sich in einem Support 18', wobei dieser mit Schrauben 18a verstellbar auf der Hohlwelle 6 fixierbar ist. Die Kraftübertragung des Drehstabes 19a auf das drehbare Panel erfolgt im oberen Rahmenteil 10 und ist durch einen gestrichelt eingezeichneten Bolzen 19c symbolisiert.

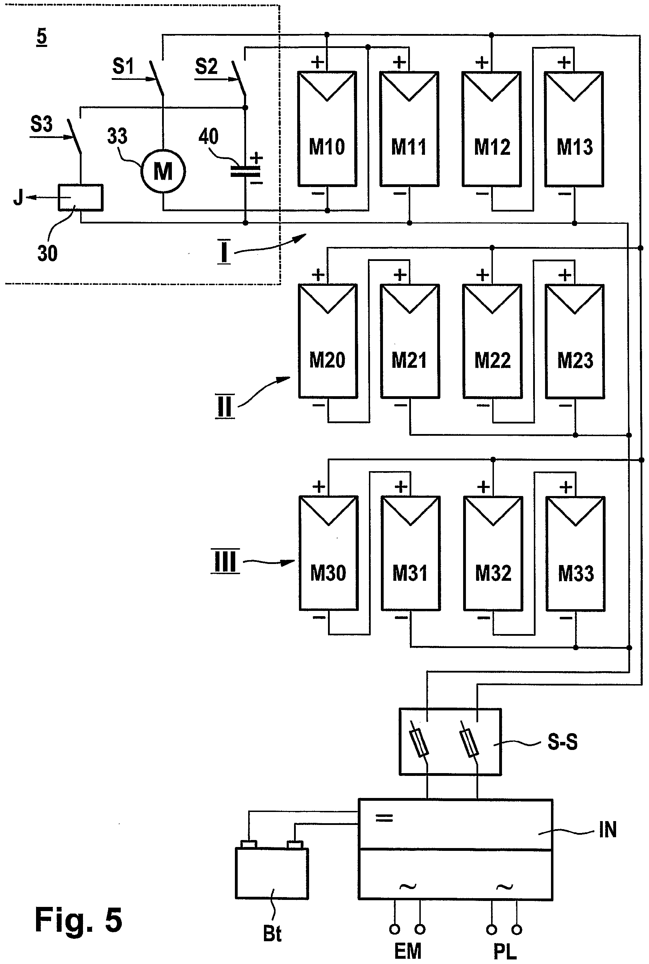

Nach Fig. 5 verwendet eine Notstromversorgung mit Rückspeisung ins Stromnetz drei zueinander parallel geschaltete kippbare Solarpanels I-III mit Modulen M10-M33. Eingesetzt ist hierfür ein handelsüblicher Inverter IN (Sun Profi Emergency, SP 1500 E der Firma Sun Power Solartechnik GmbH, D-61118 Bad Vilbel). Dieser lädt Batterien Bt (Gleichspannung) und speist ins Stromnetz die laufend gewonnene Solarleistung in Form einer einphasigen Wechselspannung ein. Der zugehörige Netzanschluss ist mit PL (Power Line) bezeichnet. Der zweite Ausgang EM (Emergency) des Inverters IN gibt unverzüglich eine Spannung ab, wenn das Stromnetz ausfällt. Die Speisung erfolgt dann durch die Batterien Bt, welche tagsüber nachgeladen werden. Zwischen den Solarmodulen M10 bis M33 der Panels I-III und dem Inverter IN ist ein Trennschalter S-S mit integrierten Sicherungen geschaltet.

Für diese Anwendung genügt wiederum eine einzige elektrische Antriebseinheit 5 für die Schwenkbewegung der Panels I-III. Der Getriebemotor 33 wird über einen Schalter durch ein Signal S1 kurzzeitig an ein oberes Solarmodul M10 angeschlossen, was zu einer Schwenkbewegung um beispielsweise 7.5 Winkelgrade führt. Ebenfalls wird während eines kurzen Intervalls durch ein Steuersignal S2 ein weiteres Modul M11 an den Speicherkondensator 40 angeschlossen und dieser mit der vollen Klemenspannung von beispielsweise 45 V geladen. Durch ein Steuersignal S3 kann zu gegebener Zeit mit der im Kondensator 40 gespeicherten Energie der Schaltmagnet 30 betätigt werden.

Daraus ergibt sich eine äusserst einfache zeitgerechte Steuerung der Schwenkbewegung: Durch das Steuersignal S1 werden die Panels I-III jeweils um 7.5° bewegt, solange die Sonne genügend Energie abgibt. Bleibt diese für eine längere Zeit aus, oder sind - im Normalfall abends - die Panels in ihre westliche Endlage gekippt, so wird der Schaltmagnet 30 durch das Steuersignal S3 betätigt, was einen mechanischen Impuls J auf die Schaltwippe 25, 25' ergibt und den Kondensator 40 entlädt, siehe Fig. 2. Dadurch wird das Zwischenrad 32' vom Zahnradsegment 21 abgehoben, so dass die Rückstellfeder 19, (vgl. Fig. 1; Fig. 4) die Panels I-III in ihre horizontale Null-Lage dreht. Anschliessend schwenkt die Schaltwippe 25,25', durch die Blattfeder 28,28' betätigt, nach oben und klinkt das Zahnrad 32' wieder in die Verzahnung 23 ein. Somit können die einzelnen durch die Positionsgeber P1-Pn vorgegebenen Schwenkwinkel zeitlich vorbestimmt angefahren werden.

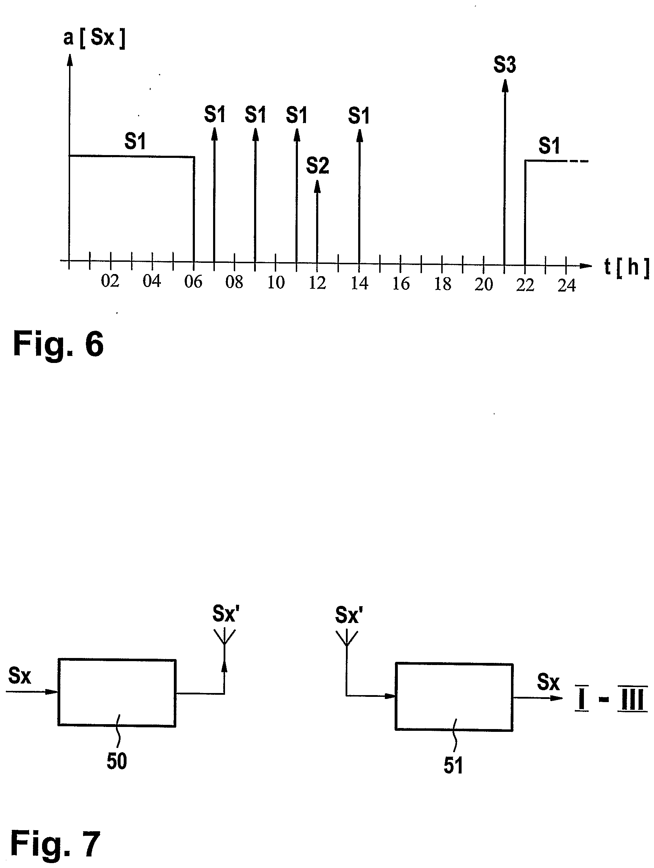

Diese Art der zeitabhängigen Steuerung erlaubt eine volle Berücksichtigung des Sonnenstands, ohne dass solare Sensoren nötig sind. Dies ist im charakteristischen Ablauf beispielhaft in Fig. 6 dargestellt, wo die Aktion a als Funktion der Zeit t im Tagesablauf durch die Signale S1-S3 eingezeichnet ist.

Dabei bedeuten:
S1 = Steuersignal für Getriebemotor 33 (Schwenkbewegung)
S2 = Steuersignal zur Ladung des Elektrolytkondensators 40
S3 = Steuersignal zur Auskupplung des Getriebes (auf Schaltwippe 25, 25'), was zu einer Rückstellung R in die Null-Lage 0. führt.

Eine Möglichkeit zur Signalübertragung von einem sogenannten "Master" (Steuereinheit) auf "Slaves" ist durch die Übertragungsstrecke nach Fig. 7 aufgezeigt. Ein Sender 50 (WLAN) transformiert ein Steuersignal Sx nach Fig. 6 in ein Sendesignal Sx'; dieses wird im Empfänger 51 wiederum zum Signal Sx transformiert und den Panels I und/oder I-III zugeführt. Die Kopplung zwischen den Panels I-III kann somit mechanisch oder elektrisch erfolgen.

Eine hochfrequente Signalübertragung lässt sich mit günstigen Komponenten und notorisch bekannten Verfahren der mobilen Computertechnik (z.B. Bluetooth) auch für grosse solare Installationen leicht realisieren und entsprechend elektrisch versorgen, dies ohne spürbare Einbussen in der solaren Leistungsbilanz.

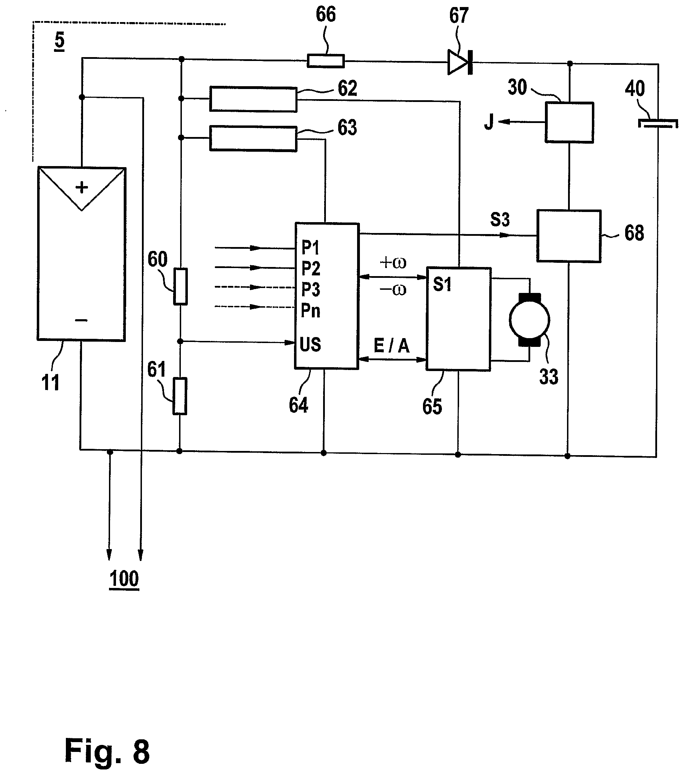

In einem bevorzugten Ausführungsbeispiel, Fig. 8, erhält eine Antriebseinheit 5 ihre Energie von einem einzigen Solarmodul 11. Über einen Spannungsregler 62 und eine Brückenschaltung 65 wird der Getriebemotor 33 gespeist. Die Speisung eines Mikroprozessors 64 erfolgt über einen Spannungsregler 63. Mit dem Abgriff einer am Modul 11 angeschlossenen Widerstandsbrücke 60,61 ist der Schwellenwerteingang US des Mikroprozessors 64 verbunden und schaltet diesen bei einer genügend hohen Eingangsspannung, beispielsweise 38 V in seinen Funktionszustand.

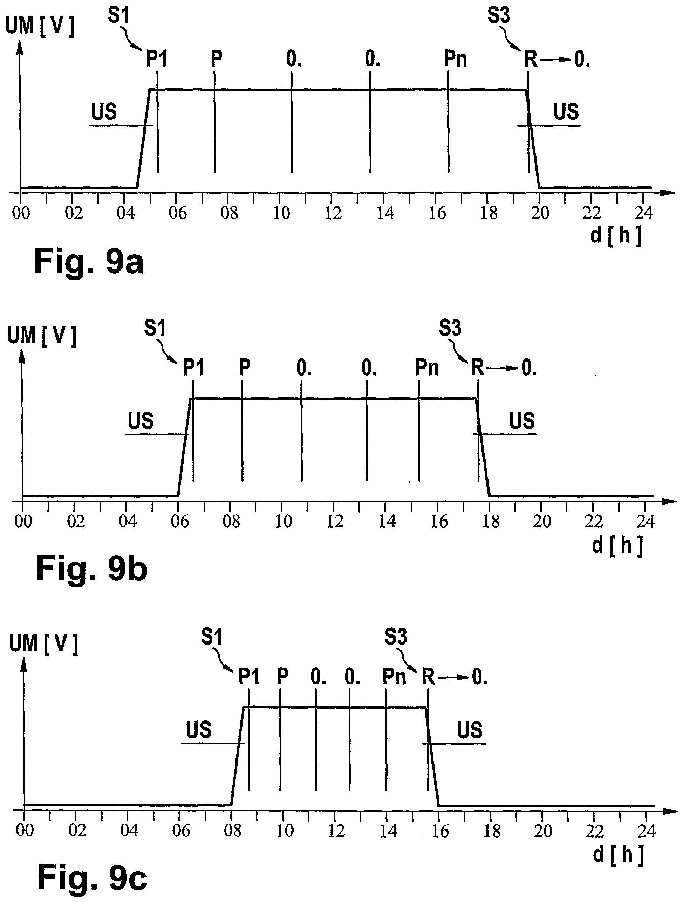

Dies ist aus den Diagrammen Fig. 9a-9c ersichtlich, wobei Fig. 9a die Klemmenspannung UM (in Volt) am Modul in einer typischen Sommerphase, Fig. 9b den Spannungsverlauf UM im Frühjahr oder Herbst und Fig. 9c eine typische Winterphase darstellen. Betrachtet man Fig. 2 in Verbindung mit den Fig. 9a-9c, so ist ersichtlich, dass die Magnetstäbe 48 auf einem Teilkreis des Zahnsegmentes 21 in gleichen Abständen eingelassen sind. Sie bilden zusammen mit dem Reed-Schalter 49 Positionsgeber P1-Pn. Durch die im Mikroprozessor 64 (Fig. 8) errechnete präsumptive Tageslänge werden die zeitlichen Intervalle zwischen den Einzelschritten von P1-Pn gleichmässig aufgeteilt. Je nach Tageslänge sind die Intervalle kürzer (z.B. Fig. 9c) oder länger (Fig. 9a). Das im Mikroprozessor 64 gespeicherte Programm steuert das Panel 1 somit adaptiv ("Adaptive Steuerung").

Sobald die Schwellenwertspannung US erreicht ist, beginnt ein im Prozessor 64 (Fig. 8) enthaltener Zähler mit seiner Zählfunktion und stoppt bei einer Unterschreitung der Spannung US. Damit ist ein Tagesablauf mit seiner effektiven Sonnenscheindauer speicherbar; dies wird täglich wiederholt und aus den Messwerten der letzten 8 Tagen ein Mittelwert gebildet, welcher der sequentiellen Aufteilung der Steuersignale in die Einzelschritte P1, P2 bis Pn dient. Ein Vergleich des Diagramms vom Sommer, Fig. 9a mit dem Winter, Fig. 9c zeigt, wie sich die Schrittlänge ändert. Damit ergibt sich eine automatische Adaption des Systems an die Jahreszeit, d.h. bei kürzerer Sonnenscheindauer erfolgt eine verbesserte Anpassung an die Einstrahlungsrichtung.

Die typischen Horizonalstellungen des Panels 1 bzw. 1' sind als Null-Lagen 0. bezeichnet; vgl. Fig. 9a-9c. Das Signal S3 bewirkt hier ebenfalls das vorgängig beschriebene Ausschwenken des Zahnrades 32' und dadurch die Rückstellung R des Panels in die Null-Lage 0. Danach rastet das Zahnrad 32' wieder ein; die Anlage ist nun bereit, schon beim Auftreten einer diffusen morgendlichen Dämmerung, beim wieder Erreichen der Schwellenwertspannung US, Steuersignale S1 abzugeben, um zuerst die Position P1 und dann in zeitlicher Folge die weiteren Positionen P2 bis Pn gemäss Fig. 9a-9c anzufahren.

Die Rückmeldung der Signale der Positionsgeber P1 bis Pn ist am Mikroprozessor 64, Fig. 8, eingezeichnet; dadurch wird die Stromzufuhr zur Brückenschaltung 65 und zum Motor 33 unterbrochen, was in der Fig. 8 als E bzw. als A eingetragen ist. Die Drehrichtungsumkehr -ω/+ω erfolgt ebenfalls an diesem als Doppelbrücke ausgeführten Baustein 65.

Während in Fig. 5 von elektromagnetischen Schaltern (Relais) S-S mit entsprechenden galvanischen Trennungen ausgegangen wurde, sind nach Fig. 8 Halbleiterelemente verwendet.

Die Ladung des Elektrolytkondensators 40, Fig. 8, erfolgt über einen seriellen Widerstand 66 und eine Sperrdiode 67, d.h. eventuelle Leckströme im Kondensator 40 werden automatisch kompensiert. Das Steuersignal S3 ist vom Mikroprozessor 64 dem Schalteingang eines elektronischen Schalters 68 (CMOS FET) zugeführt, welcher den Schaltmagneten 30 ansteuert.

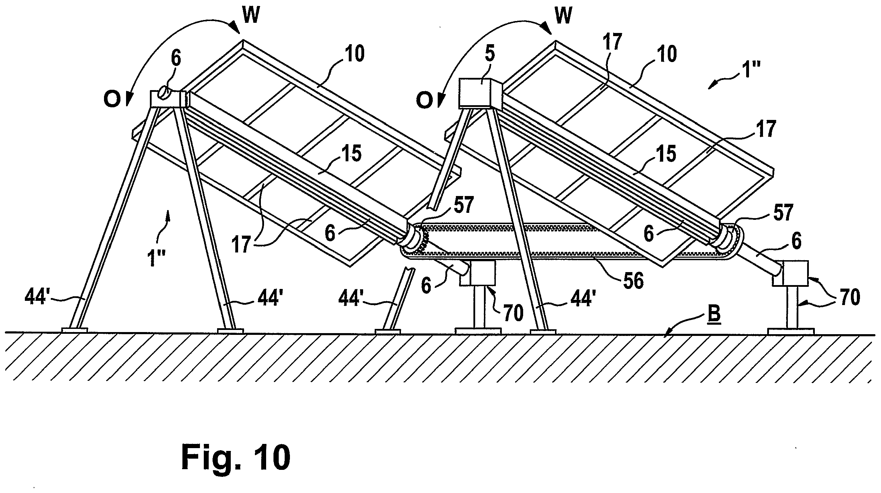

In Fig. 10 ist ein bevorzugtes Ausführungsbeispiel einer aus zwei Panels 1" bestehenden Anlage aufgezeigt, welche beide einen Elevationswinkel von 30° aufweisen. Die Wellen 6 der beiden Panels 1" sind wiederum in Stützen 44' sowie zusätzlich in einem niedrigen Ständer 70 fixiert. Das Ganze ist auf einem Beton-Flachdach eines Gebäudes aufgebaut. Ein einziger Antrieb 5 steuert autonom beide Panels 1". Die Kopplung über einen Zahnriemen 56 ist vereinfacht dargestellt, sie verläuft in Wirklichkeit in einem "Kettenkasten" und enthält an sich bekannte Spannglieder, um temperaturbedingte Dehnungen zu kompensieren.

In dieser Variante wurde auf eine Rückstellung mittels eines Federstabs 19 verzichtet; vgl. Fig. 1 und Fig. 4. Dies geschieht hier über den Antrieb 5 und die Zahnriemen 56. Eine Blockierung der Zahnriemen während der horizontalen Nullstellung, beispielsweise an deren Spanngliedern, ergibt über die elastischen Riemen 56 ebenfalls eine angestrebte Federwirkung.

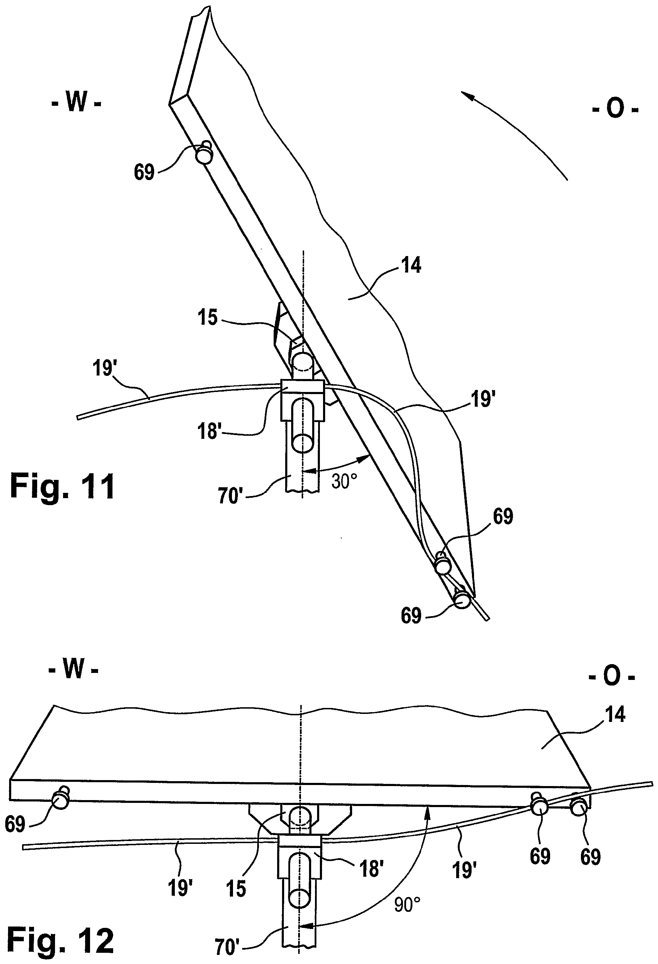

In einzeln gesteuerten Anlagen haben sich Federstäbe 19' mit rechteckförmigem Querschnitt (Blattfeder) nach Fig. 11 bis 13 bewährt.

Aus Fig. 11 ist ersichtlich wie das Panel in seiner nach Osten (O) gekippten Lage die Blattfeder 19', stirnseitig am Modul 14 spannt und diesem, auch bei einem am Morgen noch am Antrieb vorhanden nur kleinen Drehmoment zur Drehbewegung in Pfeilrichtung nach Westen verhilft. Die erforderliche Federkraft lässt sich durch Verdrehen und Festklemmen - mittels hier nicht dargestellter Schrauben - am verstellbaren Support 18' leicht experimentell einstellen. Geführt ist die Blattfeder an metallischen Rollen 69.

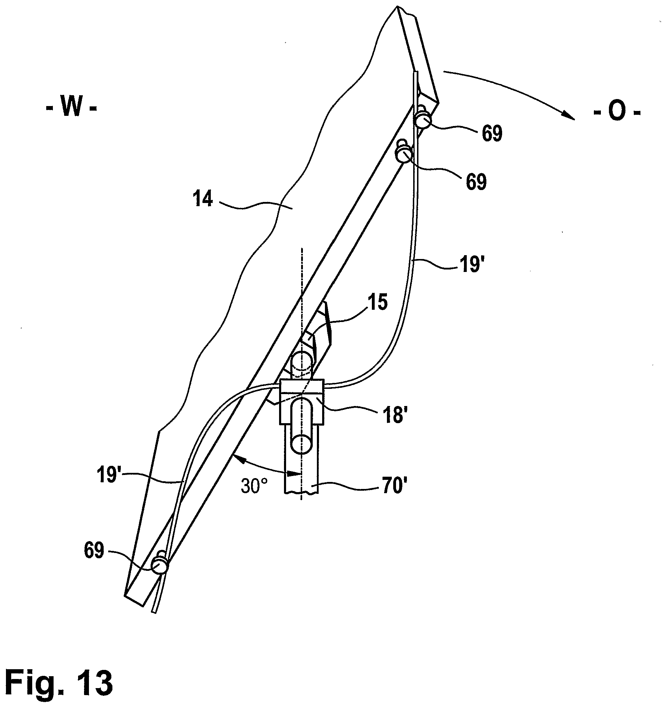

Form und Lage der Blattfeder am Mittag sind in Fig. 12 zu sehen; ebenso am Abend in Fig. 13.

Im Gegensatz zum vorherigen Ausführungsbeispiel beträgt hier der gesamte Schwenkwinkel 120°, was in Fig. 11 und 13 durch die Ergänzungswinkel von 30° zum Ständer 70' dargestellt ist. In Anlagen mit sehr effizienten Wechselrichtern mit MPP (Maximum Power Point) -Regelung wird bekanntlich auch in der letzten Dämmerungsphase noch Energie konvertiert, so dass vorteilhafterweise die Rückstellung des Panels erst bei vollständiger Dunkelheit erfolgt. Zu diesem Zweck empfiehlt es sich einen weiteren Ladekondensator für die Speisung der Stromversorgung der Steuerung einzusetzen, dies analog zum Elektrolytkondensator 40. Diese Bufferung gewährleistet auch ein zeitgerechtes Starten der Steuerung, selbst dann wenn der Wechselrichter die minimal vorhandene Energie in der Morgendämmerung "absaugt" und die Speisespannung für die Stromversorgung nicht ausreichen sollte.

Eine einzige derartige Anlage erlaubt je nach Art der Solarmodule leicht eine maximale Leistung Pp von 1600 W zu erzielen und kann der zuverlässigen Versorgungssicherheit von auch grossen Servern und/oder Kommunikationszentralen, ggf. auch im Dauer-Notstrombetrieb, dienen. Selbst bei wechselhafter Bewölkung sind abends die hierfür erforderlichen Bufferbatterien geladen; an solchen Tagen beträgt der Energiegewinn gegenüber stationären Anlagen bis zu 36%. Der Kombinations- und Anpassungsmöglichkeit des Erfindungsgenstands sind nur wenige Grenzen gesetzt, erlaubt doch die autonome und leistungsmässig nicht ins Gewicht fallende Ausgestaltung der zeitgerechten Steuerung von optimierten Solaranlagen individuelle Anpassungen an spezifische Anwendungen und an die hierfür zum Einsatz gelangenden technischen Mittel.

Selbstverständlich kann die Anlage auch in der Elevation an die Sonnenstellung Winter/Sommer angepasst werden. Mit einem entsprechenden technischen Aufwand liesse sich der Erfindungsgenstand auch als zweiachsige Nachführung ausführen, was aber aus wirtschaftlichen Gründen derzeit als unzweckmässig erscheint. Die einfache konstruktive Ausgestaltung ermöglicht nahezu überall den Aufbau einer erfindungsgemässen Anlage und erlaubt damit zahlreichen Fällen das nachrüsten bestehender Anlagen unter Beibehaltung der elektrischen Infrastruktur (Wechselrichter, Netzeinspeisung etc.). Messungen haben gezeigt, dass eine einachsig nachgeführte Anlage bei stark wechselnder Bewölkung einen Mehrertrag von bis zu 36 % gegenüber stationären Anlagen bei gleicher Elevation liefern kann.

Die in den Ausführungsbeispielen dargestellten Verstellschritte des Panels sind in ihrer Anzahl nur durch die Konstruktion der Positionsgeber P1-Pn (Interferencen) begrenzt. Aus Wirtschaftlichkeitsgründen kommen mehr als 16 Schritte kaum in Frage.

Der Erfindungsgegenstand ist ein Beitrag an eine gesicherte und umweltfreundliche Energieversorgung zu wirtschaftlichen Bedingungen.

## Patentansprüche

1. Solaranlage mit mindestens einem fotovoltaischen Solarmodul, welches durch einen elektrischen Antrieb intermittierend und programmgesteuert um eine stationäre Welle schwenkbar, auf im Tagesablauf maximale Sonneneinstrahlung ausrichtbar ist, wobei die Speisung der Schwenkbewegung des elektrischen Antriebs der Steuerung durch ein zur Energiegewinnung bestimmtes Solarmodul erfolgt, **dadurch gekennzeichnet, dass** die Welle (6,6') auf einer Endseite ein festsitzendes Zahnrad (21) trägt, um welches ein mit dem Support (15) für die Solarmodule (11-14) kraftschlüssig verbundener Antrieb (5) sektoriell und tageszeitabhängig geführt ist, der damit das Solarmodul auf die Sonne ausrichtet und dass die in Achsrichtung gesehenen Module (11-14) stirnseitig zueinander durch Distanzhalter (16) und Luftspalte (17) beabstandet sind und dass die Distanzhalter (16) aus einem Elastomer bestehen und eine Breite von 15-50 mm, bevorzugt 20 mm aufweisen.

2. Solaranlage nach Anspruch 1, **dadurch gekennzeichnet, dass** an der Welle (6) wenigstens ein Federstab (19,19') fixiert ist, welcher peripher an einem Rahmen (10) angreift, welcher die Solarmodule (11-14) fasst.

3. Solaranlage nach Anspruch 1, **dadurch gekennzeichnet, dass** der elektrische Antrieb (5) an einer Stirnseite des Solarpanels (1,1') angeflanscht ist, dass das Zahnrad (21) auf der feststehenden Welle (6) als Zahnradsegment ausgebildet ist, dass das eine Zahnrad (32') eines Getriebes (32';32,34) in das Zahnrad (21) eingreift, und dass der Getriebemotor (33) im Vorlauf (+ω) und im Rücklauf (+ω) den gesamten Antrieb (5) um die Welle (6) um einen Zentriwinkel von wenigstens 90° schrittweise schwenkt.

4. Solaranlage nach Anspruch 3, **dadurch gekennzeichnet, dass** das Getriebe (32';32,34) und der Getriebemotor (33) auf einer Schaltwippe (25,25') montiert und damit vom Zahnradsegment (21) ausrückbar sind.

5. Solaranlage nach Anspruch 4, **dadurch gekennzeichnet, dass** die Schaltwippe (25,25') durch Federn (28,28') in die Richtung des Zahnradsegmentes (21) belastet ist und dass in der Gegenrichtung ein Schaltmagnet (30) vorgesehen ist, der durch seine Ansteuerung die Schaltwippe (25,25') und damit das Antriebszahnrad (32') aus dem Zahnradsegment (21) ausrückt.

6. Solaranlagen nach Anspruch 1, **dadurch gekennzeichnet, dass** wenigstens zwei Solarmodule (11,12) vorgesehen sind, wobei das eine Modul (11) intermittierend den Getriebemotor (33) des Antriebs (5) und das andere Modul (12) die Stromversorung der Steuerung und/oder wenigstens ein Schaltglied zur Auskopplung eines Getriebes (32';32,34) von einer feststehenden Welle (6) speist.

7. Solaranlage nach einem der Ansprüche 3 bis 6, **dadurch gekennzeichnet, dass** das Getriebe (32';32,34) ein Stirnradgetriebe ist.

8. Solaranlage nach Anspruch 1, **dadurch gekennzeichnet, dass** bei mehreren benachbarten Solarpanels (1,1') ein zentraler elektrischer Antrieb (5) vorgesehen ist, welcher mechanisch über Treibmittel (56) oder über eine Funkverbindung (50,51) die Schwenkbewegungen der Solarpanels (1,1') miteinander synchronisiert.

9. Verfahren zum Betrieb einer Solaranlage mit mindestens einem fotovoltaischen Solarmodul, welches durch einen elektrischen Antrieb intermittierend und programmgesteuert um eine stationäre Welle schwenkbar, auf im Tagesablauf maximale Sonneneinstrahlung ausrichtbar ist, wobei die Speisung der Schwenkbewegung des elektrischen Antriebs der Steuerung durch ein zur Energiegewinnung bestimmtes Solarmodul erfolgt, **dadurch gekennzeichnet, dass** über einen Mikroprozessor (64) ein elektrischer Schwellenwert (US) an einem Solarmodul (11-14) erfasst wird, welcher der morgendlichen und abendlichen Dämmerung entspricht, dass daraus durch einen Zählvorgang die Dauer des Tageslichts erfasst wird, dass dieser Wert im Mikroprozessor (64) gespeichert wird, dass aus den Speicherwerten von mehreren Tagen ein Mittelwert gebildet wird, dass dieser Mittelwert in gleiche Einzelschritte (P1-Pn) aufgeteilt wird, dass die resultierenden Intervalle (P1, P2-Pn) den Getriebemotor (33) mit einem Signal (S1) ansteuern, derart, dass sich die Einzelschritte der Schwenkbewegung des Panels (1) von Ost (O) nach West (W) über den Tagesablauf wenigstens annähernd gleichmässig verteilen und dass während oder nach der abendlichen Dämmerung das Panel (1) nach Osten (O) zurückgedreht wird.

10. Verfahren nach Anspruch 9, **dadurch gekennzeichnet, dass** der angesteuerte Getriebemotor (33) durch Positionsgeber (48) und wenigstens einen Positionssensor (49) temporär abgeschaltet wird.

11. Verfahren nach Anspruch 9, **dadurch gekennzeichnet, dass** im Tagesablauf durch ein Solarmodul (11-14) ein Kondensator (40) aufgeladen wird, dass bei der abendlichen Dämmerung oder nachts, nach einer Unterschreitung der Schwellenwertspannung (US) vom Mikroprozessor (64) ein Steuersignal (S2) an einen Leistungsschalter (68) abgegeben wird und dass dieser die im Kondensator (40) gespeicherte Ladung an ein Solenoid eines wenigstens einen Schaltmagneten (30) schaltet, welcher durch den resultierenden mechanischen Impuls (J) eine Schaltwippe (25,25') und damit ein Getriebe (32;32',34) aus einem Zahnradsegment (21) kurzzeitig ausrückt, und dass dadurch eine mechanische Vorspannung der Schwenkbewegung des Panels (1) freigeschaltet wird, wodurch dessen Rückstellung in die Ostlage (O) erfolgt.

12. Verfahren nach Anspruch 11, **dadurch gekennzeichnet, dass** der Kondensator (40) am Tage ständig mit der Spannung eines Solarmoduls (11) beaufschlagt ist und dass vor dem Kondensator (40) eine Sperrdiode (67) geschaltet wird, die laufend dessen Leckstrom kompensiert.

13. Verfahren nach Anspruch 12, **dadurch gekennzeichnet, dass** der Kondensator (40) sich über einen zweiten Magneten entlädt, der in die Schaltwippe (25,25') eingreift, und 100 bis 300 ms vor dem ersten Schaltmagneten (30) aktiviert wird, und dabei die Schaltwippe (25,25') entriegelt.

## Claims

1. A solar plant with at least one photovoltaic solar module which is pivotable about a stationary shaft by an electrical drive in an intermittent and program-controlled manner and is capable of being directed for the maximum solar radiation in the course of the day, wherein the pivoting movement of the electrical drive of the control means is supplied by a solar module intended for energy generation, **characterized in that** on one end face the shaft (6, 6') carries a fixed gearwheel (21) about which a drive (5) connected in a non-positively locking manner to the support (15) for the solar modules (11 to 14) is guided in a sectoral manner dependent upon the time of day and thus directs the solar module towards the sun and that the modules (11 to 14) as viewed in the axial direction, are arranged at a distance from one another at their end faces by spacer elements (16) and air gaps (17), and the spacer elements (16) consist of an elastomer and have a width of from 15 to 50 mm, preferably 20 mm.

2. A solar plant according to Claim 1, **characterized in that** at least one spring rod (19, 19'), which engages peripherally on a frame (10) which grips the solar modules (11 to 14), is fixed to the shaft (6).

3. A solar plant according to Claim 1, **characterized in that** the electrical drive (5) is flange-mounted on an end face of the solar panel (1, 1'), the gearwheel (21) is constructed in the form of a gearwheel segment on the fixed shaft (6), one gearwheel (32') of a gear mechanism (32'; 32, 34) engages in the gearwheel (21), and the gear motor (33) pivots the entire drive (5) step-wise about the shaft (6) by a central angle of at least 90° in advance (+ω) and in return (+ω).

4. A solar plant according to Claim 3, **characterized in that** the gear mechanism (32'; 32, 34) and the gear motor (33) are mounted on a rocker switch (25, 25') and are thus capable of being moved away from the gearwheel segment (21).

5. A solar plant according to Claim 1, **characterized in that** the rocker switch (25, 25') is stressed by springs (28, 28') in the direction of the gearwheel segment (21), and a switching magnet (30), which by its actuation moves the rocker switch (25, 25') and thus the driving gearwheel (32') out of the gearwheel segment (21), is provided in the opposite direction.

6. A solar plant according to Claim 1, **characterized in that** at least two solar modules (11, 12) are provided, wherein one module (11) supplies the gear motor (33) of the drive (5) in an intermittent manner and the other module (12) provides the current supply of the control means and/or at least one switch member for uncoupling a gear mechanism (32'; 32, 34) from a fixed shaft (6).

7. A solar plant according to any one of Claims 3 to 6, **characterized in that** the gear mechanism (32'; 32, 34) is a spur-gear mechanism.

8. A solar plant according to Claim 1, **characterized in that** in the case of a plurality of adjacent solar panels (1, 1') a central electrical drive (5), which synchronizes the pivoting movements of the solar panels (1, 1') with one another mechanically by way of drive means (56) or by way of a radio link (50, 51), is provided.

9. A method of operating a solar plant with at least one photovoltaic solar module which is pivotable about a stationary shaft by an electrical drive in an intermittent and program-controlled manner and is capable of being directed for the maximum solar radiation in the course of the day, wherein the pivoting movement of the electrical drive of the control means is supplied by a solar module intended for energy generation, **characterized in that** an electrical threshold value (US), which corresponds to the dawn and twilight, is detected on a solar module (11 to 14) by way of a microprocessor (64), the duration of the daylight is determined therefrom by a counting process, this value is stored in the microprocessor (64), an average is formed from the stored values of several days, the said average is divided into equal individual steps (P1, P2 to Pn), the resulting intervals (P1, P2 to Pn) actuate the gear motor (33) with a signal (S1) in such a way that the individual steps of the pivoting movement of the panel (1) from east (O) to west (W) are divided at least approximately uniformly over the course of the day, and the panel (1) is turned back towards the east (O) during or after the twilight.

10. A method according to Claim 9, **characterized in that** the actuated gear motor (33) is temporarily switched off by position transmitters (48) and at least one position sensor (49).

11. A method according to Claim 9, **characterized in that** a capacitor (40) is charged by a solar module (11 to 14) in the course of the day, and that during the twilight or at night when the threshold-value voltage (US) fails to be reached a control signal (S2) is transmitted by the microprocessor (64) to a power switch (68), and the said power switch (68) switches the charge stored in the capacitor (40) to a solenoid of at least one switching magnet (30) which on account of the resulting mechanical pulse (J) moves a rocker switch (25, 25') and thus a gear mechanism (32; 32', 34) from a gearwheel segment (21) for a short time, and, as a result, a mechanical prestressing of the pivoting movement of the panel (1) is released, as a result of which it is moved back into the east position (O).

12. A method according to Claim 11, **characterized in that** the capacitor (40) is constantly acted upon during the day with the voltage of a solar module (11), and a blocking diode (67), which continuously compensates the leakage current of the capacitor (40), is connected upstream of the said capacitor (40).

13. A method according to Claim 12, **characterized in that** the capacitor (40) is discharged by way of a second magnet which engages in the rocker switch (25, 25') and is activated from 100 to 300 ms before the first switching magnet (30), and in this case the rocker switch (25, 25') is unlocked.

## Revendications

1. Installation solaire avec au moins un module solaire photovoltaïque qui, par l'intermédiaire d'un entraînement électrique, peut être entraîné en rotation autour d'un arbre fixe de façon intermittente et commandée par programme et est orientable vers un rayonnement solaire maximal au cours de la journée, dans laquelle l'alimentation du mouvement pivotant de l'entraînement électrique du dispositif de commande s'effectue par un module solaire de production d'énergie, **caractérisée en ce que** l'arbre (6,6') porte une roue dentée fixe (21) sur un côté d'extrémité, autour de laquelle un entraînement (5) relié par coopération de forces au support (15) pour les modules solaires (11-14) est guidé de manière sectorielle et dépendante du moment de la journée, qui oriente ainsi le module solaire vers le soleil, **en ce que** les modules (11-14) vus dans la direction axiale sont espacés les uns des autres au niveau de leur face frontale par des entretoises (16) et des entrefers (17) et **en ce que** les entretoises (16) sont en un élastomère et présentent une largeur de 15 à 50 mm, de préférence de 20 mm.

2. Installation solaire selon la revendication 1, **caractérisée en ce qu'**au moins une tige à ressort (19,19') est fixée à l'arbre (6) qui vient en prise périphériquement avec un cadre (10) qui retient les modules solaires (11-14).

3. Installation solaire selon la revendication 1, **caractérisée en ce que** l'entraînement électrique (5) est bridé à une face frontale du panneau solaire (1,1'), **en ce que** la roue dentée (21) sur l'arbre fixe (6) est formée comme un segment de roue dentée, **en ce qu'**une roue dentée (32') d'une transmission (32' ; 32, 34) entre en prise dans la roue dentée (21), et **en ce que** le motoréducteur (33) fait tourner l'entraînement complet (5) par pas autour de l'arbre (6) dans le sens avant (+ω) et dans le sens arrière (+ω) selon un angle au centre d'au moins 90°.

4. Installation solaire selon la revendication 3, **caractérisée en ce que** la transmission (32' ; 32, 34) et le motoréducteur (33) sont montés sur un levier de commutation (25, 25') et peuvent ainsi être désengagés du segment de roue dentée (21).

5. Installation solaire selon la revendication 4, **caractérisée en ce que** le levier de commutation (25, 25') est chargé par des ressorts (28, 28') dans la direction du segment de roue dentée (21) et **en ce qu'**un aimant de commutation (30) est prévu dans la direction opposée qui, par son activation, désengage du segment de roue dentée (21) le levier de commutation (25, 25') et donc la roue dentée d'entraînement (32').

6. Installation solaire selon la revendication 1, **caractérisée en ce qu'**au moins deux modules solaires (11, 12) sont prévus, dans laquelle le premier module (11) alimente par intermittence le motoréducteur (33) de l'entraînement (5), et l'autre module (12) alimente l'alimentation en courant du dispositif de commande et/ou au moins un élément de commutation pour le découplage d'une transmission (32' ; 32, 34) d'un arbre fixe (6).

7. Installation solaire selon l'une des revendications 3 à 6, **caractérisée en ce que** la transmission (32' ; 32, 34) est un engrenage droit.

8. Installation solaire selon la revendication 1, **caractérisée en ce que**, dans le cas de plusieurs panneaux solaires adjacents (1,1'), un entraînement électrique central (5) est prévu, lequel synchronise mécaniquement les mouvements de pivotement des panneaux solaires (1, 1') les uns avec les autres au moyen d'agents moteurs (56) ou par une connexion sans fil (50, 51).

9. Procédé de fonctionnement d'une installation solaire avec au moins un module solaire photovoltaïque lequel peut pivoter par un entraînement électrique autour d'un arbre fixe de façon intermittente et pilotée par programme et est orientable vers un rayonnement solaire maximal pendant la journée, dans lequel l'alimentation du mouvement oscillant de l'entraînement électrique du dispositif de commande s'effectue par un module solaire de production d'énergie, **caractérisé en ce qu'**une valeur de seuil électrique (US) est enregistrée dans un module solaire (11-14) par un microprocesseur (64), qui correspond au lever du jour et à la tombée de la nuit, **en ce que** la durée de la lumière du jour est enregistrée sur cette base par une opération de comptage, **en ce que** cette valeur est mémorisée dans le microprocesseur (64), **en ce qu'**une moyenne est formée à partir des valeurs mémorisées de plusieurs jours, **en ce que** cette moyenne est répartie en pas individuels identiques (P1-Pn), **en ce que** les intervalles en résultant (P1, P2-Pn) commandent le motoréducteur (33) avec un signal (S1) de telle sorte que les pas individuels du mouvement pivotant du panneau (1) se répartissent au moins approximativement régulièrement de l'Est (O) vers l'Ouest (W) sur l'ensemble de la journée et **en ce que**, pendant ou après la tombée de la nuit, le panneau (1) est de nouveau pivoté vers l'Est (O).

10. Procédé selon la revendication 9, **caractérisé en ce que** le motoréducteur commandé (33) est temporairement arrêté par des générateurs de position (48) et au moins un capteur de position (49).

11. Procédé selon la revendication 9, **caractérisé en ce qu'**un condensateur (40) est rechargé au cours de la journée par un module solaire (11-14), **en ce qu'**un signal de commande (S2) est envoyé à un commutateur de puissance (68) par le microprocesseur (64) à la tombée de la nuit ou pendant la nuit, après un sous-passement de la tension de seuil (US), **en ce que** celui-ci commute la charge stockée dans le condensateur (40) à un solénoïde d'au moins un aimant de commutation (30) lequel, par l'impulsion mécanique (J) qui en résulte, désengage brièvement d'un segment de roue dentée (21) le levier de commutation (25, 25') et donc une transmission (32 ; 32', 34), et **en ce qu'**une précontrainte mécanique du mouvement pivotant du panneau (1) en est libérée, de sorte que sa remise à la position Est (O) a lieu.

12. Procédé selon la revendication 11, **caractérisé en ce que** le condensateur (40) est chargé en continu avec la tension d'un module solaire (11) pendant la journée, et **en ce qu'**une diode de blocage (67) est montée avant le condensateur (40), qui compense en continu le courant de fuite de celui-ci.

13. Procédé selon la revendication 12, **caractérisé en ce que** le condensateur (40) se décharge par l'intermédiaire d'un second aimant qui entre en prise dans le levier de commutation (25, 25') et est activé 100 à 300 ms avant le premier aimant de commutation (30) et déverrouille ainsi le levier de commutation (25, 25').
